(19) **Europäisches Patentamt**

**European Patent Office**

**Office européen des brevets**

(11) **EP 1 100 976 B1**

(12) **EUROPEAN PATENT SPECIFICATION**

(45) Date of publication and mention
of the grant of the patent:
**03.03.2004 Bulletin 2004/10**

(51) Int Cl.$^7$: **C22C 29/08**

(86) International application number:
**PCT/SE1999/001220**

(21) Application number: **99933440.2**

(22) Date of filing: **05.07.1999**

(87) International publication number:
**WO 2000/003048 (20.01.2000 Gazette 2000/03)**

(54) **CEMENTED CARBIDE INSERT WITH BINDER PHASE ENRICHED SURFACE ZONE**

INSERT AUS ZEMENTIERTEM KARBID MIT BINDERANGEREICHERTER OBERFLÄCHENZONE

PLAQUETTE EN CARBURE METALLIQUE DOTEE D'UNE ZONE SUPERFICIELLE ENRICHIE PAR PHASE LIANTE

(84) Designated Contracting States:
**AT BE CH CY DE DK ES FI FR GB GR IE IT LI LU MC NL PT SE**

(30) Priority: **09.07.1998 SE 9802487**

(43) Date of publication of application:
**23.05.2001 Bulletin 2001/21**

(73) Proprietor: **SANDVIK AKTIEBOLAG**
**811 81 Sandviken (SE)**

(72) Inventors:
• **WALDENSTRÖM, Mats**
**S-167 71 Bromma (SE)**
• **AKESSON, Leif**
**S-125 51 Älvsjö (SE)**

(74) Representative: **Taquist, Lennart et al**
**Sandvik AB**
**Patent Department**
**811 81 SANDVIKEN (SE)**

(56) References cited:
**EP-A2- 0 240 879        WO-A1-98/03691**

**Description**

The present invention relates to coated cemented carbide cutting tool inserts with a binder phase enriched surface zone, particularly useful for turning and drilling in steels and stainless steels.

Coated cemented carbide inserts with binder phase enriched surface zones are today used to a great extent for machining of steel and stainless materials. Through the binder phase enriched surface zone an extension of the application area is obtained.

Methods of producing binder phase enriched surface zones on cemented carbides containing WC, gamma phase. (Ti,Ta,Nb)C, and binder phase are known as gradient sintering and have been known for some time, e.g., through Tobioka (US Patent 4,277,283, Nemeth (US Patent 4,610,931), Taniguchi (US Patent 4,830,283), Okada (US Patent 5,106,674 and Gustafson (US Patent 5,649,279).

Conventional cemented carbide inserts are produced by powder metallurgical methods including milling of a powder mixture forming the hard constituents and the binder phase, pressing and sintering. The milling operation is an intensive milling in mills of different sizes and with the aid of milling bodies. The milling time is of the order of several hours up to several days. Such processing is believed to be necessary in order to obtain a uniform distribution of the binder phase in the milled mixture. It is further believed that the intensive milling creates a reactivity of the mixture which further promotes the formation of a dense structure. However, milling has its disadvantages. During the long milling time the milling bodies are worn and contaminate the milled mixture. Furthermore, even after an extended milling a random rather than an ideal homogeneous mixture may be obtained. Thus, the properties of the sintered cemented carbide containing two or more components depend on how the starting materials are mixed. Further, the extensive milling process generates a large fraction of very fine grained carbide particles that during the sintering process will cause a in many cases unwanted grain growth. The grain growth process often leads to the formation of a fraction of very large carbide particles especially of WC, which can deteriorate the thermomechanical properties of the cutting insert.

There exist alternative technologies to intensive milling for production of cemented carbide, for example, use of particles coated with binder phase metal. The coating methods include fluidized bed methods, solgel techniques, electrolytic coating, PVD coating or other methods such as disclosed in e.g. GB 346,473, US 5,529,804 or US 5,505,902. Coated carbide particles can be mixed with additional amounts of cobalt and other carbide powders to obtain the desired final material composition, pressed and sintered to a dense structure.

It has now surprisingly been found that cemented carbide inserts with binder enriched surface zone made from powder mixtures with cobalt coated hard constituents with narrow grain size distributions and without conventional milling have excellent cutting performance in steels and stainless steels in turning and drilling under both dry and wet conditions. Furthermore, it has been found that due to the very uniformly distributed binder phase on the carbide particles, it is possible to use a lower sintering temperature and still get a dense structure, especially valid at lower binder contents. It has also been found that a much higher cooling rate in combination with the lower sintering temperature gives the most optimal binder enriched surface structure for the application area mentioned above.

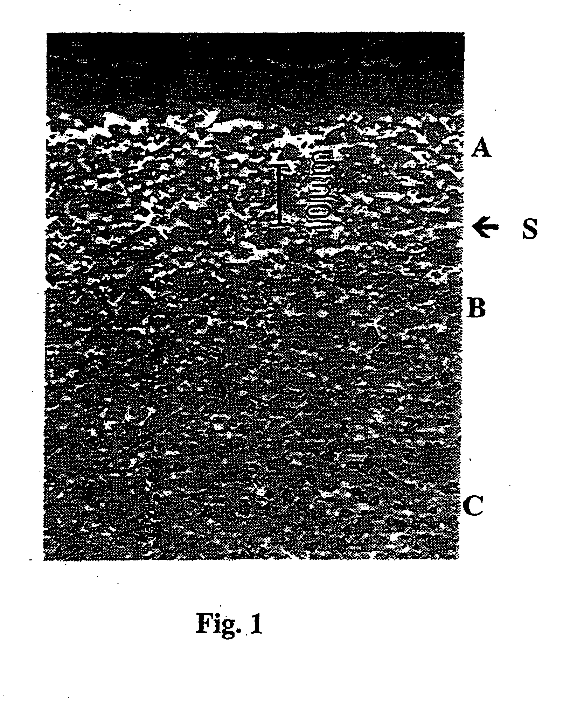

Fig 1 shows in 1300X magnification the surface zone of an insert according to the invention where

　　　A - the outer part of the surface zone essentially free of gamma phase
　　　B - the inner part of the surface zone containing gamma phase
　　　C - unaffected substrate
　　　S - striation

According to the present invention, which is defined by the appended claims, there is now provided a cemented carbide with a <65 $\mu$m, preferably 20-40 $\mu$m, thick binder phase enriched surface zone, A+B. The outer part, A, of this binder phase enriched surface zone, at least 5 $\mu$m, preferably <20 $\mu$m thick, is essentially free of gamma phase. The inner part, B, of the surface zone, at least 10 $\mu$m, preferably <30 $\mu$m, thick, contains gamma phase as well as stratified binder phase layers, S. The stratified binder phase layers are in this inner part, part B, well developed whereas they are thin and with very small spread in the outer part of the surface zone, part A. The binder phase content of the binder phase enriched surface zone has a maximum in the inner part, B, of 1.5-4, preferably 2-3, times the nominal binder phase content. In addition, the tungsten content of the inner part, B, of the surface zone is <0.95, preferably 0.75-0.9, of the nominal tungsten content. The binder phase enriched surface zone as well as an about 100-300 $\mu$m thick zone below it, part C, with essentially nominal content of WC, gamma phase and binder phase contain no graphite. However, in the interior of the cemented carbide according to the invention there is a C-porosity of C06-C08. On top of the cemented carbide surface there is a thin, 1-2 $\mu$m, cobalt and/or graphite layer.

The WC-grains have an average grain size in the range 1.0-3.5 $\mu$m, preferably 1.3-3.0 $\mu$m and a very narrow grain size distribution. The number of WC-grains larger than 2 times the average grain size is less than 10 grains/cm$^2$ measured on a representative polished section 0.5 cm$^2$ large, preferably less than 5 grains/cm$^2$, and the number larger than 3 times the average grain size is less than 5 grains/cm$^2$, preferably less than 3 grains/cm$^2$. In addition, the gamma phase, when present, exhibits a lower tendency to form long range skeleton, compared to conventional cemented carbide.

The amount of Co-based binder phase can vary between 2 and 10% by weight, preferably between 4 and 8% by weight, most preferably between 5.5 and 7 % by weight. The amount of gamma phase forming elements can be varied rather freely. The process works on cemented carbides with varying amount of titanium, tantalum, niobium, vanadium, tungsten and/or molybdenum. The optimum combination of toughness and deformation resistance is achieved with a total amount of cubic carbides TiC, TaC, NbC etc corresponding to 4-15% by weight, preferably 7-10% by weight. In order to obtain the desired microstructure nitrogen has to added, either through the powder or through the sintering process. As a result the cemented carbide contains between 0.1 and 3% by weight N per % by weight of group IVB and VB elements. Although the material contains carbonitride rather than carbide . it is generally referred to as cemented carbide.

According to the method of the present invention, defined by the appended claims, the cemented carbide is manufactured by jetmilling/sieving a WC-powder to a powder with narrow grain size distribution in which the fine and coarse grains are eliminated. To obtain the above-mentioned narrow grain size distribution it has been found that the WC-grains of the powder shall have a size within the range $0.1d_m$-$3d_m$, preferably $0.2d_m$-$2d_m$ where $d_m$ is desired average grain size. This WC powder is then coated with Co according to any of the above mentioned US-patents. The WC-powder is carefully wet mixed with cubic carbides and an optimum amount of carbonitrides or nitrides to a slurry, possibly with more Co to obtain the desired final composition and pressing agent. The optimum amount of nitrogen depends on the amount of gamma phase and can vary between 0.1 and 3% by weight per % by weight of group IVB and VB elements.

The amount of carbon required to achieve the desired stratified structure according to the present invention coincides with the eutectic composition, i.e. graphite saturation. The optimum amount of carbon is, thus, a function of all other elements and cannot easily be stated. The carbon content can be controlled either by a very accurate blending and sintering procedure or by a carburization treatment in connection with the sintering.

Furthermore, in order to avoid sedimentation of the coated WC-particles thickeners are added according to WO 98/00257. The mixing shall be such that a uniform mixture is obtained without milling i.e. no reduction in grain size shall take place. The slurry is dried by spray drying. From the spray dried powder cemented carbide bodies are pressed and sintered.

The pressed bodies containing an optimum amount of carbon are sintered in an inert atmosphere or in vacuum, 15 to 180 min at a sintering temperature of 1350-1420°C, followed by slow controlled cooling, 75-240°C/h, preferably 85-200°C/h, through the solidification region, 1295-1230°C, preferably 1290-1250°C. The cooling rate must be optimised together with the sintering temperature. This relationship can be expressed as the

$$SP\text{-}value = CR \cdot (ST\text{-}1300) / 1000$$

where CR is the cooling rate in °C/h and ST is the sintering temperature in °C.

According to the invention improved cutting properties are achieved if the SP-value is between 10 and 17, preferably between 11 and 16.

An alternative route includes sintering a slightly subeutectic body in a carburising atmosphere, containing a mixture of $CH_4/H_2$ and/or $CO_2/CO$, 30-180 min at 1350-1420°C followed by slow cooling according to above in the same atmosphere, preferably in an inert atmosphere or vacuum.

Cemented carbide inserts according to the invention are preferably coated with in itself known thin wear resistant coatings with CVD- or PVD-technique. Preferably there is deposited an innermost coating of carbide, nitride or carbonitride preferably of titanium and an outer coating of preferably alumina. Prior to the deposition the cobalt- and/ or graphite layer on top of the cemented carbide surface is removed e.g. by electrolytic etching or blasting, according to e.g. US 5,380,408.

Example 1

Cemented carbide tool inserts of the type CNMG 120408-PM, an insert for turning, with the composition 6.5 wt% Co, 3.6 wt% TaC, 2.4 wt% NbC, 0.4 wt% TiCN and 2.2 wt% TiC and rest WC were produced according to the invention from a jetmilled/sieved WC-powder with an average grain size of 2.3 μm and grain sizes in the range 0.7 -3.9 μm. Cobalt coated WC, WC-2 wt% Co, prepared according to US 5,505,902 was carefully deagglomerated in a laboratory jetmill equipment, mixed with additional amounts of Co and deagglomerated uncoated (Ta,Nb)C, NbC, TiCN and (Ti,W)C powders to obtain the desired material composition. The mixing was carried out in an ethanol and water solution (0.25 l fluid per kg cemented carbide powder) for 2 hours in a laboratory mixer and the batch size was 10 kg. Furthermore, 2 wt% lubricant was added to the slurry. The carbon balance was adjusted with carbon black to 0.25 wt% overstoichiometric carbon. After spray drying, the inserts were pressed and sintered in $H_2$ up to 450°C for dewaxing and further in vacuum to 1350°C and after that in protective atmosphere of Ar for 1 h at 1380°C according to standard practice. The cooling was performed with a well controlled temperature decrease of 170°C/h within the temperature interval 1290 to 1240°C, i.e. with the SP-value equal to 13.6, in the same protective atmosphere as during the sintering. After that, the cooling continued as normal furnace cooling with maintained protective atmosphere.

The structure in the binder phase enriched surface zone of the inserts consisted of an about 7 µm thick moderately binder phase enriched outer part essentially free of gamma phase, part A, in which the stratified binder phase structure was weakly developed. Below this outer part there was a 25 µm thick zone containing gamma phase and with a strong binder phase enrichment as a stratified binder phase structure, part B. The maximum cobalt-content in this part was about 20 weight-%. Further below this part, B, there was a zone, part C, about 150-200 thick with essentially nominal content of gamma phase and binder phase but without free graphite. In the inner of the insert graphite porosity was present up to C08. The average grain size of the WC was about 2.5 µm, and the number of grains larger than 5 µm was found to be <5 grains/cm$^2$ on a polished section and the number larger than 7.5 µm was <2 grains/cm$^2$. On the surface there was a thin film of cobalt and graphite. This film was removed by an electrochemical method in connection with the edge rounding treatment. The inserts were coated according to known CVD-technique with an about 10 µm thick coating of TiCN and $Al_2O_3$.

### Example 2

As reference a similar powder mixture as in example 1 was produced by conventional milling of uncoated hard constituents. Inserts of type CNMG 120408-PM were pressed and sintered according to an identical sintering cycle as in example 1, except with a sintering temperature of 1450°C, giving an SP-value equal to 25.5. The inserts were etched, edge-rounded and CVD coated according to example 1.

The structure and average grain size of the inserts was essentially identical to that of example 1 except for three aspects:

- an apparent broader grain size distribution within the whole insert with about 40 grains/cm$^2$ larger than 5 µm and about 15 grains/cm$^2$ larger than 7.5 µm
- a less pronounced striated binder phase structure in the inner part of the surface zone, part B, with a maximum Co-content of about 14 weight-% and a thickness of about 20 µm.
- a somewhat thicker zone free of gamma phase (part A), of about 11 µm.

### Example 3

As a further reference inserts of type CNMG 120408-PM were pressed from the same powder mixture.and sintered according to an identical sintering cycle as in example 2, except that the controlled cooling rate was 60°C/h and the SP-value was 9.0. The inserts were etched, edge-rounded and CVD coated according to example 1.

The structure of the inserts was essentially identical to that of example 2 except for a somewhat thicker zone free of gamma phase (part A), about 13 µm, and a more pronounced striated binder phase structure in the inner part of the surface zone, part B, with a maximum Co-content of about 23 weight-% and a thickness of about 30 µm.

### Example 4

With the CNMG 120408-inserts from examples 1, 2 and 3, a test consisting of an intermittent turning operation with cutting fluid in an unalloyed steel SS1312 was performed with the following cutting data:

| | |
|---|---|
| Speed | 80 m/min |
| Feed | 0.40 mm/rev |
| Cutting depth | 2 mm |

15 cutting edges of each variant were run until fracture or max 10 min tool life. The average tool life is shown in the table below.

| | Average tool life, min |
|---|---|
| Example 1 (invention) | 10 (no fracture) |

(continued)

|  | Average tool life, min |
|---|---|
| Example 2 (known technique) | 7.1 |
| Example 3 (known technique) | 7.6 |

Example 5

The inserts from examples 1, 2 and 3 were tested in a continuous turning operation in a tough-hardened steel, SS2541, with the hardness HB280. The following cutting data were used.

| Speed | 140 m/min |
|---|---|
| Feed | 0.7 mm/rev |
| Cutting depth | 2.0 mm |
| Cutting time | 30 s |

The operation led to a plastic deformation, which could be observed as an edge depression of the cutting edge. The edge depression was measured for five edges of each variant and average values were compared relative to each other giving the following result (low value means good result):

|  | Relative edge depression |
|---|---|
| Example 1 (invention) | 1.00 |
| Example 2 (known technique) | 0.98 |
| Example 3 (known technique) | 1.14 |

From examples 4 and 5 it is evident that inserts according to the invention, example 1, exhibit a considerably better toughness behaviour than according to known technique without having significantly impaired deformation resistance. It is evident that a larger span in cutting properties and thereby application area can be obtained.

**Claims**

1. Coated cemented carbide comprising WC, 2-10 wt-% Co, 4-15 wt-% cubic carbides such as TiC, TaC and NbC, with a binder phase enriched surface zone essentially free of gamma phase **characterised in that** the WC-grains have an average grain size in the range 1.0-3.5 μm, preferably 1.3-3.0 μm and that the number of WC-grains larger than 2 times the average grain size is less than 10 grains/cm$^2$ measured on a representative polished section 0.5 cm$^2$ large, preferably less than 5 grains/cm$^2$, and the number larger than 3 times the average grain size is less than 5 grains/cm$^2$, preferably less than 3 grains/cm$^2$.

2. Method of making a cemented carbide according to claim 1, with a binder phase enriched surface zone essentially free of gamma phase by powder metallurgical methods mixing powders of WC, Co and cubic carbides such as TiC, TaC and NbC, pressing and sintering **characterised in**

   - **that** the WC-powder has a grain size distribution in the range 0.1d$_m$-3d$_m$, preferably 0.2d$_m$-2d$_m$, where d$_m$ is the desired average grain size of the sintered cemented carbide
   - **that** the WC-powder grains are coated with binder metal prior to the mixing
   - **that** the mixing is a gentle wet mixing with no change in grain size or grain size distribution and
   - **that** the cooling rate through the solidification region, CR, in °C/h from the sintering temperature, ST, in °C exhibits the relationship

$$10 < CR \cdot (ST\text{-}1300) / 1000 < 17.$$

**Patentansprüche**

1. Beschichtetes Hartmetall, das WC, 2 bis 10 Gew.% Co, 4 bis 15 Gew.% kubische Carbide, wie TiC, TaC und NbC, mit einer mit Bindephase angereicherten Oberflächenzone im wesentlichen frei von gamma-Phase umfaßt, **dadurch gekennzeichnet, daß** die WC-Körner eine mittlere Korngröße im Bereich von 1,0 bis 3,5 µm, vorzugsweise von 1,3 bis 3,0 µm haben und die Anzahl der WC-Körner, die größer als das Zweifache der mittleren Korngröße sind, kleiner als 10 Körner/cm$^2$, gemessen auf einem repräsentativen polierten Abschnitt von 0,5 cm$^2$, ist, vorzugsweise kleiner als 5 Körner/cm$^2$ ist, und die Anzahl, die größer als das Dreifache der mittleren Korngröße ist, kleiner als 5 Körner/cm$^2$, vorzugsweise kleiner als 3 Körner/cm$^2$ ist.

2. Verfahren zur Herstellung eines Hartmetalls nach Anspruch 1 mit einer an Bindephase angereicherten Oberflächenzone im wesentlichen frei von gamma-Phase durch pulvermetallurgische Verfahren unter Vermischen von Pulvern von WC, Co und kubischen Carbiden, wie TiC, TaC und NbC, Pressen und Sintern; **dadurch gekennzeichnet,**

   - **daß** das WC-Pulver eine Korngrößenverteilung im Bereich von 0,1 $d_m$ - 3 $d_m$, vorzugsweise 0,2 $d_m$ - 2 $d_m$ hat, wobei $d_m$ die gewünschte mittlere Korngröße des gesinterten Hartmetalls ist,

   - **daß** die WC-Pulverkörner mit Bindemetall vor dem Vermischen beschichtet werden,

   - **daß** das Vermischen ein mildes nasses Mischen ohne Veränderung der Korngröße oder Korngrößenverteilung ist und

   - **daß** die Kühlgeschwindigkeit in dem gesamten Verfestigungsbereich, CR, in °C/h von der Sintertemperatur, ST, in Grad Celsius die Beziehung

$$10 < CR\,(ST - 1300)/1000 < 17$$

   hat.

**Revendications**

1. Carbure cémenté revêtu comprenant du WC, de 2 à 10% en poids de Co, de 4 à 15% en poids de carbures cubiques tels que TiC, TaC et NbC, avec une zone de surface enrichie de phase liante sensiblement exempte de phase gamma, **caractérisé en ce que** les grains de WC ont une taille moyenne de grain située dans la plage allant de 1,0 à 3,5 µm, de préférence de 1,3 à 3,0 µm, et **en ce que** le nombre de grains de WC supérieurs à deux fois la taille moyenne de grain est inférieur à 10 grains/cm$^2$ mesuré sur une section polie représentative de 0,5 cm$^2$ de taille, de préférence inférieur à 5 grains/cm$^2$, et le nombre pour ceux supérieurs à trois fois la taille moyenne de grain est inférieur à 5 grains/cm$^2$, de préférence inférieur à 3 grains/cm$^2$.

2. Procédé de fabrication d'un carbure cémenté selon la revendication 1 avec une zone de surface enrichie de phase liante sensiblement exempte de phase gamma par les procédés de la métallurgie des poudres, comprenant l'étape de mélange des poudres de WC, Co et de carbures cubiques tels que TiC, TaC et NbC, les étapes de compression et de frittage, **caractérisé en ce que** :

   - la poudre de WC présente une distribution de taille de grain située dans la plage allant de 0,1$d_m$ à 3$d_m$, de préférence de 0,2$d_m$ à 2$d_m$, où $d_m$ représente la taille moyenne de grain désirée du carbure cémenté fritté,
   - les grains de poudre de WC sont revêtus de métal liant préalablement à l'étape de mélange,
   - l'étape de mélange est une étape de mélange doux par voie humide sans changement de la taille de grain ou de la distribution de la taille de grain, et
   - le taux de refroidissement à travers la zone de solidification, TR, en °C/h à partir de la température de frittage, TF, en °C, suit la relation

$$10 < TR \cdot (TF-1300)/1000 < 17.$$

Fig. 1